# EUROPÄISCHE PATENTSCHRIFT

(11) **EP 3 122 623 B1**
(45) Veröffentlichungstag und Bekanntmachung des Hinweises auf die Patenterteilung: **19.06.2019**
(21) Anmeldenummer: 15710507.3
(22) Anmeldetag: 18.03.2015
(51) Int. Cl.: B63B 43/00

(54) **VERFAHREN ZUR DETEKTION EINES SCHADENS AN EINER AUSSENHAUT EINES SCHIFFES UND FOLIENANORDNUNG ZUR DETEKTION EINES SCHADENS AN EINER AUSSENHAUT EINES SCHIFFES**
METHOD FOR DETECTING DAMAGE TO AN OUTER SKIN OF A SHIP AND FILM ASSEMBLY FOR DETECTING DAMAGE TO AN OUTER SKIN OF A SHIP
PROCÉDÉ DE DÉTECTION D'UN DOMMAGE SUR UNE PEAU EXTÉRIEURE D'UN BATEAU ET SYSTÈME DE FEUILLES POUR DÉTECTER UN DOMMAGE SUR UNE PEAU EXTÉRIEURE D'UN BATEAU

(30) Priorität: 28.03.2014 DE 102014104358
(43) Veröffentlichungstag der Anmeldung: 01.02.2017
(73) Patentinhaber: ThyssenKrupp Marine Systems GmbH, 24143 Kiel (DE); thyssenkrupp AG, 45143 Essen (DE)
(72) Erfinder: DETERMANN, Wolfram, 22851 Norderstedt (DE); POPALL, Christian, 25479 Ellerau (DE)
(74) Vertreter: thyssenkrupp Intellectual Property GmbH
(86) Internationale Anmeldenummer: PCT/EP2015/055674
(87) Internationale Veröffentlichungsnummer: WO 2015/144525

(56) Entgegenhaltungen:
- WO-A2-2006/028490
- DE-A1-102010 054 754
- DE-A1-102010 054 754
- US-A- 3 392 979

## Beschreibung

### Stand der Technik

Die vorliegende Erfindung betrifft ein Verfahren zur Detektion eines Schadens an einer Außenhaut eines Schiffes und eine Folienanordnung zur Detektion eines Schadens an einer Außenhaut eines Schiffes.

Schäden an der Außenhaut eines Schiffes können fatale Folgen für dessen Funktionstüchtigkeit haben. Es ist daher nicht weiter überraschend, dass ein gesteigertes Interesse daran besteht, schnellst möglichst zu erfahren, wo ein Schaden am Schiff entstanden ist. Gerade bei Marineschiffen ist eine schnelle und genaue Ortung eines Schadens entscheidend, wenn im Gefecht oder durch Sabotageakte Geschosse oder Ähnliches die Außenhaut beschädigen. Es besteht sogar die Gefahr, dass im Hafen liegende Schiffe Schäden auf der der See zugewandten Seite erfahren, die außerhalb des Sichtfelds der Besatzung liegen und deshalb möglicherweise unentdeckt bleiben. Unentdeckt könnten beispielsweise auch solche Schäden bleiben, die durch kleinkalibrige Projektile verursacht wurden und aus der Ferne mit bloßem Auge nicht erkennbar sind.

Der Stand der Technik kennt zur Identifikation und Lokalisierung eines Schadens an der Außenhaut eines Schiffes aus der Druckschrift DE 10 2010 054 754 A1 eine Folienanordnung, die an der Innenseite der Außenhaut befestigt wird und der über ein Netzwerk eine Adresse zugeordnet wird. Ein Schaden an der besagten Folienanordnung wird dann über das Netzwerk zu einer Zentraleinheit übermittelt, die dann wiederum die Besatzung darüber informiert, an welcher Stelle der Außenhaut ein Schaden vorliegt.

### Offenbarung der Erfindung

Es ist Aufgabe der vorliegenden Erfindung ein Verfahren zur Lokalisierung eine Schadens an der Außenhaut eines Schiffes zur Verfügung zu stellen, das das bereits bekannte Verfahren hinsichtlich seiner Langlebigkeit, Zuverlässigkeit und Einsatzfähigkeit weiter verbessert.

Die Aufgabe der vorliegenden Erfindung wird gelöst durch ein Verfahren zur Detektion eines Schadens an einer Außenhaut eines Schiffes mit einer Folienanordnung, bei der eine erste Leitfolie von einer zweiten Leitfolie durch eine Isolationsfolie beabstandet wird, wobei eine elektrische Spannung zwischen der ersten Leitfolie und der zweiten Leitfolie angelegt wird, wobei die elektrische Spannung derart gepolt wird, dass eine parallel zur Folienanordnung geschaltete Prüfdiode
-- in einem Detektionsmodus zur Detektion eines potenziellen Schadens an der Außenhaut des Schiffes in Sperrrichtung oder
-- in einem Funktionskontrollmodus zur Prüfung der Detektionsfähigkeit der Folienanordnung in Durchlassrichtung
betrieben wird.

Gegenüber dem Stand der Technik hat die vorliegende Erfindung den Vorteil besonders zuverlässig zu sein. Dabei wird der Schaden dadurch registriert, dass beispielsweise durch ein zumindest teilweises Zerstören der Isolationsfolie die erste und die zweite Leitfolie in elektrisch leitenden Kontakt treten und dadurch die Prüfdiode überbrücken. In Folge des Schadens setzt also ein Stromfluss ein, der andernfalls von der in Sperrrichtung betriebenen Prüfdiode unterdrückt werden würde. Die vorliegende Erfindung verzichtet dadurch in vorteilhafter Weise auf Analysen des durch die Leitfolien fließenden Stroms, um einen Schaden zu identifizierten, und ordnet stattdessen dem Einsetzen eines Stromflusses bei Betrieb des Schaltkreises in Sperrrichtung unmittelbar einen Schaden in der Außenhaut zu. Dadurch wird die Identifikation eines Schadens hinsichtlich der Zuverlässigkeit seiner Detektion verbessert. Weiterhin lässt sich in regelmäßigen Abständen überprüfen, ob der Schaltkreis aus der ersten und der zweiten Leitfolie auf Grund einer unvorhergesehenen Ursache möglicherweise keinen Strom führt. Dadurch lässt sich in vorteilhafter Weise die Zuverlässigkeit des Verfahrens auch über lange Zeiträume kontrollieren und sicherstellen.

Vorzugsweise sind die erste Leitfolie, die zweite Leitfolie und die Isolationsfolie zumindest teilweise stoffschlüssig miteinander verbunden. Beispielsweise sind die einzelnen Folien mit Epoxidharz im Vakuumverfahren miteinander verbunden. Der Begriff Folie wird in der Folge auch als Oberbegriff für erste Leitfolie, zweite Leitfolie und Isolationsfolie benutzt. Es ist weiterhin denkbar, dass leitende Bereiche der ersten bzw. der zweiten Leitfolie zumindest teilweise von einem Isolationsmaterial, das dann als Isolationsfolie zu verstehen ist, ummantelt sind. Vorzugsweise erstrecken sich die Folien flächig und sind entlang einer Stapelrichtung, vorzugsweise bündig, zueinander angeordnet. Die Ausdehnung der Folienanordnung entlang der Stapelrichtung ist vorzugsweise kleiner als 5 mm. Weiterhin ist es bevorzugt, dass die Folien ein geringes Gewicht aufweisen, bevorzugt weniger als 1.5 kg/m² wiegen. Da die Folien bevorzugt an allen Flächen der Außenhaut angebracht werden sollen, kann durch ein geringes Eigengewicht der einzelnen Folien in der Summe eine signifikante Gewichtzunahme durch das Anbringen der Folien am Schiff vermieden werden.

Vorteilhafte Ausgestaltungen und Weiterbildungen der Erfindung sind den Unteransprüchen, sowie der Beschreibung unter Bezugnahme auf die Zeichnungen entnehmbar.

In einer weiteren Ausführungsform der vorliegenden Erfindung ist es vorgesehen, dass zwischen dem Detektionsmodus und dem Funktionskontrollmodus gewechselt wird, wobei die Prüfdiode länger in Sperrrichtung betrieben wird als in Durchlassrichtung. Insbesondere ist es vorgesehen, dass eine Funktionalitätskontrolle automatisiert ist und eigenständig von einer Steuer- und Kontrolleinheit durchgeführt wird. Zudem ist es denkbar, dass eine Funktionalitätskontrolle durch eine Eingabe einer Besatzung des Schiffs beispielsweise vor dem Auslaufen aus dem Hafen initiiert wird, um nach einer längeren Ruhezeit des Schiffes die Funktionalität der Folienanordnung sicherzustellen. Vorzugsweise wird darauf geachtet, dass die Funktionalitätskontrolle so wenig Zeit in Anspruch nimmt, dass ein dauerhafter Betrieb der Folienanordnung zur Detektion von Schäden sichergestellt werden kann.

In einer weiteren Ausführungsform der vorliegenden Erfindung ist es vorgesehen, dass die erste Leitfolie und/oder die zweite Leiterfolie von einem Folienträger mit darauf rasterförmig angeordneten, elektrisch leitenden Längsbahnen und/oder Querbahnen gebildet wird. Durch eine besonders feinmaschige Anordnung der Längs- und Querbahnen lassen sich in vorteilhafter Weise auch Schäden identifizieren und schließlich lokalisieren, die durch kleinkalibrige Projektile verursacht wurden.

In einer weiteren Ausführungsform der vorliegenden Erfindung ist es vorgesehen, dass die elektrisch leitenden Längsbahnen und/oder Querbahnen durch eine mit Hilfe eines Druckverfahrens auf dem Folienträger aufgetragenen Beschichtung gebildet werden. Dadurch lässt sich auf unkomplizierte und reproduzierbare Art und Weise eine rasterförmige Beschichtung realisieren, die die Grundlage für eine zuverlässige Funktionalität der Folienanordnung stellt.

In einer weiteren Ausführungsform ist es vorgesehen, dass zwischen einer Ausrichtung der Längsbahnen der ersten Leitfolie und der Ausrichtung der Längsbahnen der zweiten Leitfolie ein von Null verschiedener Winkel, vorzugsweise ein rechter Winkel, ausgebildet wird. Dadurch wird in vorteilhafter Weise die Wahrscheinlichkeit reduziert, dass trotz eines Durchbruchs der Folienanordnung durch die Anordnung der Leiterbahnen kein für die Detektion des Schadens erforderlicher elektrischer Kontakt zustande kommt.

In einer weiteren Ausführungsform ist es vorgesehen, dass die erste Leitfolie, die zweite Leitfolie und die Isolationsfolie gemeinsam an der Außenhaut des Schiffes angeordnet werden. Vorzugsweise wird die Folienanordnung an der Innenseite der Außenhaut, d. h. an der dem Schiffsinneren zugewandten Seite der Außenhaut, angeordnet, vorzugsweise an ihr befestigt. Insbesondere ist die Folienanordnung flächig mit einem Polyurethan-Kleber an der Außenhaut des Schiffes befestigt. Dabei ist es vorstellbar, dass die Folienanordnung mit Aussparungen ausgestattet wird, durch die Vorsprünge der Außenhaut durchgeführt werden können. Insbesondere wird die Folienanordnung an Bord zugeschnitten und die zugeschnittene Folienanordnung an der Außenhaut angebracht. Dadurch lässt sich die Folienanordnung in vorteilhafter Weise möglichst passgenau an die Außenhaut des Schiffes, vorzugsweise zwischen Spanten und Stringern, anbringen.

In einer weiteren Ausführungsform ist es vorgesehen, dass ein System aus der erste Leitfolie der Isolationsfolie, der zweiten Leitfolie und der Prüfdiode mit einer Steuer -und Kontrolleinheit betrieben wird. Insbesondere ist es vorgesehen, dass eine Vielzahl der Folienanordnungen an der Außenhülle des Schiffes angebracht ist, wobei jeder einzelnen Folienanordnungen eine Adresse zugeordnet ist. Die einzelnen Steuer- und Kontrolleinheiten kommunizieren dann mit einer Zentraleinheit, in der alle Infomationen über die einzelnen Folienanordnungen zusammenlaufen und ausgewertet werden. Umso feinmaschiger die einzelnen Folienanordnungen an der Außenhaut angebracht sind, desto höher ist die Auflösung bei der Lokalisierung des potenziellen Schadens.

Ein weiterer Gegenstand der vorliegenden Erfindung ist eine Folienanordnung zur Detektion von Schäden an einem Schiff, wobei die Folienanordnung eine zwischen einer ersten Leitfolie und einer zweiten Leitfolie angeordnete Isolationsfolie aufweist, wobei eine Prüfdiode parallel zur Folienanordnung geschaltet ist, wobei die Prüfdiode in einem Detektionsmodus in Sperrrichtung und in einem Funktionskontrollmodus in Durchlassrichtung betreibbar ist.

Gegenüber dem Stand der Technik hat die erfindungsgemäße Folienanordnung den Vorteil bei einem Schaden, beispielsweise verursacht durch ein durch die Folienanordnung geschossenes Projektil, die Prüfdiode durch einen entstandenen Kontakt zwischen der ersten und der zweiten Leitfolie zu überbrücken und den so initiierten Stromfluss zum Nachweis eines Schadens an der Außenhaut des Schiffes zu nutzen.

In einer weiteren Ausführungsform der vorliegenden Erfindung ist es vorgesehen, dass die erste und/oder die zweite Leitfolie eine rasterförmige Beschichtung bestehend aus elektrisch leitenden Längsbahnen und Querbahnen umfasst. Dabei legt eine durch die rasterförmige Beschichtung bestimmte Maschengröße im Wesentlichen fest, wie groß ein Schaden sein muss, um detektiert zu werden. Es gilt dabei: Umso kleiner die Maschengröße, desto geringer ist die durch die Folienanordnung noch festzustellende Mindestgröße für einen detektierbaren Schaden.

In einer weiteren Ausführungsform der vorliegenden Erfindung ist es vorgesehen, dass die Folienanordnung an eine Steuer-und Kontrolleinheit angeschlossen ist. Vorzugsweise umfasst die Steuer und-Kontrolleinheit auch
-- die Spannungsversorgung für den Betrieb des Schaltkreises und/oder
-- eine Vorrichtung, mit der ein Stromfluss durch den Schaltkreis registrierbar bzw.
detektierbar ist. Weiterhin ist denkbar, dass die Steuer- und Kontrolleinheit ein Umschalter umfasst, mit dem die Polung des Schaltkreises von einem Betrieb in Sperrrichtung zu einem Betrieb in Durchlassrichtung und umgekehrt durchführbar ist. Zudem ist die Steuer- und Kontrolleinheit mit einer Zentraleinheit verbunden, die über einen Schaden am Schiff oder eine Funktionsfehlers der Folienanordnung informiert werden kann. Durch die Steuer-und Kontrolleinheit lässt sich die Zuverlässigkeit und die Kontrolle über die Funktionstüchtigkeit der Folienanordnung weiter verbessern.

In einer weiteren Ausführungsform ist es vorgesehen, dass die Längs und/oder Querbahnen eine Metall oder ein Karbon aufweist. Vorzugsweise weisen die Längsbahnen und/oder Querbahnen ein Material wie beispielsweise Aluminium Gaze, Niro Gaze, Aluminiumfolie, Kohlefaserleinwand/körper und/oder Kupfer auf. Die Isolationsfolie weist bevorzugt ein Material wie beispielsweise Polyethylen, WPD, Neopren, BBR, Glasfaserleinwand/körper, Aramidfaserleinwand/körper und/oder Mylarfolie auf.

In einer weiteren Ausführungsform ist es vorgesehen, dass die Folienanordnung für eines der oben beschriebenen Verfahren verwendet wird.

Ein weiterer Gegenstand ist ein Schiff mit einer Folienanordnung, wie sie oben beschrieben wurde.

In einer weiteren Ausführungsform ist es vorgesehen, dass eine Vielzahl an Folienanordnungen über die Außenhaut des Schiffes verteilt angeordnet ist und die einzelnen Folienanordnungen jeweils einen Teilbereich der Außenhaut auf mögliche Schäden überwacht. Umso großflächiger die Außenhaut mit Folienanordnungen ausgestattet ist, desto geringer ist die Wahrscheinlichkeit, dass ein Schaden unbeobachtet bleibt.

Weitere Einzelheiten, Merkmale und Vorteile der Erfindung ergeben sich aus den Zeichnungen, sowie aus der nachfolgenden Beschreibung von bevorzugten Ausführungsformen anhand der Zeichnungen. Die Zeichnungen illustrieren dabei lediglich beispielhafte Ausführungsform der Erfindung, welche den Erfindungsgedanken nicht einschränken.

### Kurze Beschreibung der Figuren

Die **Figur 1** zeigt eine Folienanordnung an der Außenhaut eines Schiffes in einer ersten beispielhaften Ausführungsform der vorliegenden Erfindung.

Die **Figur 2** zeigte ein Teil des Verfahrens zur Detektion eines Schadens an der Außenhaut eines Schiffes gemäß einer ersten beispielhaften Ausführungsform der vorliegenden Erfindung.

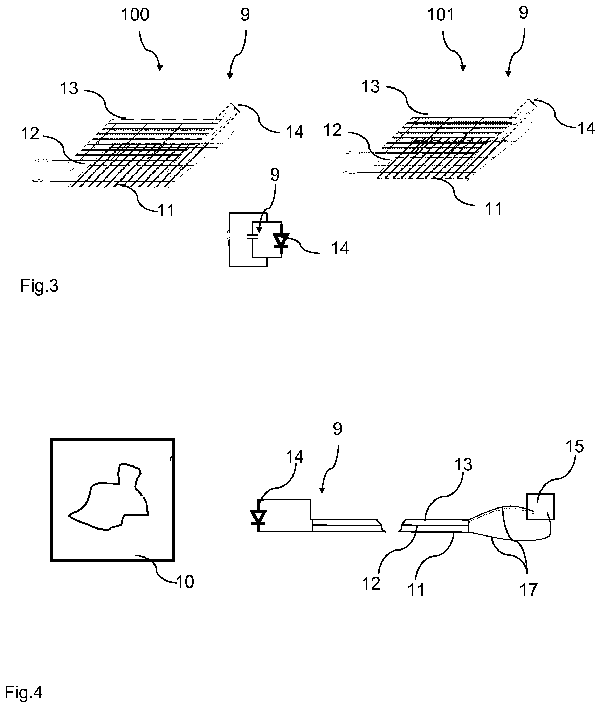

Dir **Figur 3** zeigt einen weiteren Teil des Verfahrens zur Detektion des Schadens an der Außenhaut gemäß einer zweiten beispielhaften Ausführungsform der vorliegenden Erfindung.

Die **Figur 4** zeigt eine beschädigte Folienanordnung gemäß einer zweiten beispielhaften Ausführungsform der vorliegenden Erfindung

### Ausführungsformen der Erfindung

In den verschiedenen Figuren sind gleiche Teile stets mit den gleichen Bezugszeichen versehen und werden daher in der Regel auch jeweils nur einmal benannt bzw. erwähnt.

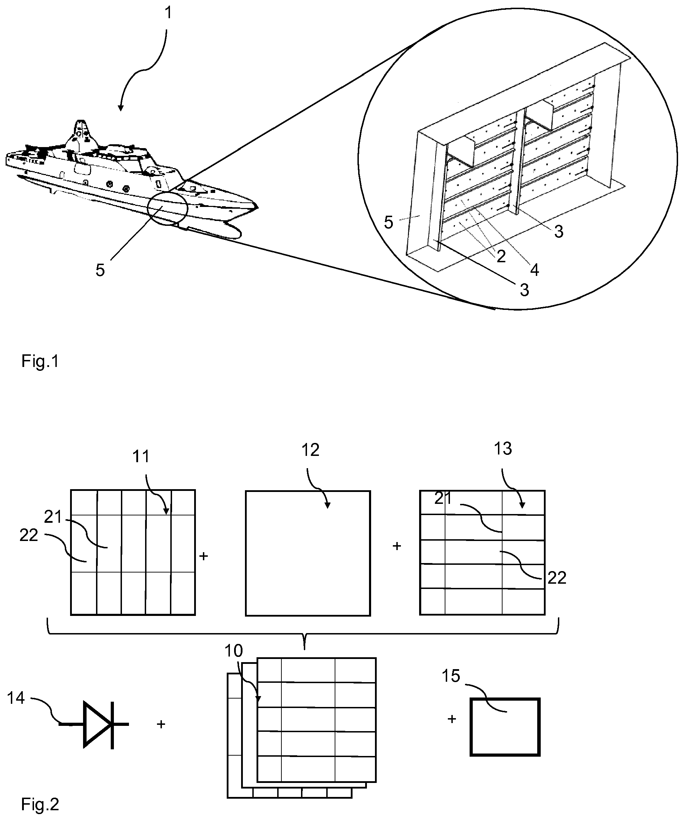

In **Figur 1** ist ein Schiff 1 dargestellt, für das die vorliegende Erfindung beispielsweise gedacht ist. Dabei ist es vorgesehen, dass mit der vorliegenden Erfindung Schäden am Schiff 1, insbesondere an dessen Außenhaut 5, erfasst und lokalisiert werden können, um möglichst schnell und zielgenau Maßnahmen zur Behebung dieser Schäden in die Wege zu leiten. Schäden an der Außenhaut 5 können beispielsweise durch das Auflaufen des Schiffes 1 auf Riffe, Eisschollen oder andere Hindernisse erfolgen. Handelt es sich bei dem Schiff um ein Marineschiff besteht zusätzlich zu den oben genannten Gefahren noch die Möglichkeit, dass die Außenhaut 5 des Schiffs durch Geschosse, herumfliegende Trümmer im Gefecht oder durch Sabotage geschädigt wird. Zur Detektion wird die Außenhaut 5 des Schiffes 1 vorzugsweise an ihrer Innenseite, d. h. der zum Schiffsinneren zeigenden Seite, mit einer Folienanordnung 10 ausgestattet, die der Detektion eines Schadens dient. Dabei wird die Folienanordnung 10 bevorzugt flächig auf Bereiche der Außenhaut 5, die zwischen Spanten 3 und Stringern 4 des Schiffs 1 liegen, aufgebracht, insbesondere aufgeklebt.

In **Figur 2** ist ein Teil eines Verfahrens zur Detektion eines Schadens am Schiff 1, beispielsweise an dessen Rumpf, gemäß einer beispielhaften Ausführungsform der vorliegenden Erfindung dargestellt. Der hier dargestellte Teil des Verfahrens betrifft die Anordnung einer ersten Leitfolie 11, einer zweiten Leitfolie 13 und einer Isolationsfolie 12. Dabei sorgt die Isolationsfolie 12 dafür, dass die erste Leitfolie 11 und die zweite Leitfolie 13 derart voneinander separiert sind, dass sich ein Kondensator ausbildet. Die erste und die zweite Leitfolie 11 und 13 weisen dabei eine Beschichtung bestehend aus elektrisch leitenden Längsbahnen 21 und Querbahnen 22 auf, die sich rasterförmig auf einem Folienträger erstrecken. Vorzugsweise werden die Längs- und Querbahnen 21 und 22 auf den Folienträger, der vorzugsweise Kunststoff aufweist, mittels eines Druckverfahrens aufgetragen und weisen ein Material wie beispielsweise Aluminium Gaze, Niro Gaze, Aluminiumfolie, Kohlefaserleinwand/körper und/oder Kupfer auf. Die Isolationsfolie 12 weist bevorzugt ein Material wie beispielsweise Polyethylen, WPD, Neopren, BBR, Glasfaserleinwand/körper, Aramidfaserleinwand/körper und/oder Mylarfolie auf. Für die Folienanordnung 10 ist es vorgesehen, dass die Isolationsfolie 12 zwischen der ersten Leitfolie 11 und der zweiten Leitfolie 13 angeordnet wird und dadurch die erste Leitfolie11 von der zweiten Leitfolie 13 trennt bzw. elektrisch isoliert. Dabei werden die erste und die zweite Leitfolie 11 und 13 derart ausgerichtet, dass deren Längsbahnen 21 zwar in im Wesentlichen parallel zueinander verlaufenden Ebenen angeordnet sind, aber nicht parallel zueinander ausgerichtet sind. Mit anderen Worten: Die Längsbahnen 21 der ersten Leitfolie 11 kreuzen die Längsbahnen 21 der zweiten Leitfolie 22, wenn man die Folienanordnung 10 in einer Draufsicht betrachten würde. Der zwischen den Längsbahnen 21 der ersten und der zweite Leitfolie 11 und 13 eingeschlossene Winkel beträgt vorzugsweise 90°. Im Falle von senkrecht zueinander verlaufenden Längsbahnen 21 ist es vorgesehen, dass eine Rasterung von Längs- und Querbahnen 21 und 22 so gewählt wird, dass die Querbahnen 22 der ersten Leitfolie 11 nicht über den Längsbahnen 21 der zweiten Leitfolie 13 bzw. die Querbahnen 22 der zweiten Leitfolien 13 nicht über den Längsbahnen 21 der ersten Leitfolie 11 verlaufen.

Vorzugsweise sind die Längs- und die Querbahnen 21 und 22 jeweils äquidistant zueinander angeordnet, wobei die Anzahl der Längsbahnen 21 größer ist als die der Querbahnen 22. Weiterhin ist es vorgesehen, dass die gefertigte Folienanordnung 10 derart ausgestaltet ist, dass sie an Bord zugeschnitten werden kann, ohne dass die Gefahr besteht, dass an einer Schnittkante der Folienanordnung 10 die Möglichkeit für einen Kontakt zwischen den jeweiligen Strukturen der Leitfolien besteht. Dazu müssen die Längen der Längsbahnen 21 und Querbahnen 22 entsprechend angepasst werden.

Weiterhin ist es vorgesehen, dass parallel zu dem aus erster Leitfolie 11, Isolationsfolie und zweiter Leitfolie 13 gebildeten Kondensator eine Prüfdiode 14 geschaltet wird. Über Anschlüsse sind die erste und die zweite Leitfolie 11 und 13 jeweils mit einer Steuer- und Kontrolleinheit 15 verbunden. Die Steuer- und Kontrolleinheit 15 umfasst beispielsweise eine Spannungsquelle, eine Kommunikationseinheit die elektrische Signale an eine Zentraleinheit weiterleitet und/oder einen Umschalter. Insbesondere ist die Spannungsquelle derart polbar, dass die zwischen der ersten Leitfolie 11 und der zweiten Leitfolie 13 geschaltete Prüfdiode 14 in einem Detektionsmodus in Sperrrichtung 100 oder in einem Funktionskontrollmodus in Durchlassrichtung 101 betreibbar ist. Vorzugsweise lässt sich mittels des Umschalters die Spannung über der Prüfdiode 14 derart umpolen, dass von einer Polung in Sperrrichtung 100 zu einer Polung in Durchlassrichtung 101 gewechselt werden kann. Die Kommunikationseinheit sorgt schließlich dafür, dass die Information über einen Schaden an der Außenhaut 5 als elektrisches Signal an die übergeordnete Zentraleinheit weitergeleitet wird, die die eingegangen Information verarbeitet und an eine Kommandobrücke des Schiffs 1 als visuelles und/oder akustisches Signal ausgibt. Insbesondere erscheint auf einem Bildschirm eine Darstellung des Schiffs 1, in die die Lokalität des detektierten Schadens eingetragen ist.

In **Figur 3** ist ein weiterer Teil des Verfahrens zur Detektion eines Schadens gemäß einer weiteren Ausführungsform der vorliegenden Erfindung dargestellt. Der hier illustrierte Teil des Verfahrens betrifft das Bertreiben der Folienanordnung 10 nachdem sie gefertigt und an der Außenhaut 5 des Schiffs angebracht wurde. Es ist hierbei vorgesehen, dass die parallel zur Folienanordnung geschaltete Prüfdiode 14 im Sinne eines NO-Prinzips zur Detektion des Schadens in Sperrrichtung 100 betrieben wird. Kommt es zur Schädigung der Außenhaut 5, beispielsweise durch ein Geschoss bzw. Projektil, geraten die erste und die zweite Leitfolie 11 und 13, insbesondere deren Längs und/oder Querbahnen, in Kontakt und überbrücken dadurch die in Sperrrichtung geschaltete Prüfdiode 14. Es kommt zum Stromfluss, der als Nachweis für einen Schaden an der Außenhülle 5 verstanden werden kann. Um die Funktionalität der Folienanordnung 10 mit der Prüfdiode 14 zu prüfen und zu überwachen ist es vorgesehen, den Schaltkreis 9 nach gewissen Zeitspannen kurzfristig in Durchlassrichtung 101 zu betreiben. Insbesondere ist es vorgesehen, dass in regelmäßigen Abständen eine Funktionalitätskontrolle durch ein Schalten des Schaltkreises 9 mittels des Umschalters in Durchlassrichtung 101 erfolgt. Dabei wird das Schalten in Sperrrichtung 101 vorzugsweise nur kurz unterbrochen. In der Abbildung ist zusätzlich in einem Ersatzschaltbild der Schaltkreis dargestellt, in den die Folienanordnung 9 und die Prüfdiode 14 integriert sind. Dabei ist die Prüfdiode 14 parallel zur Folienanordnung 9 geschaltet, die den Kondensator bildet. Über die Polung der angelegten Spannung lässt sich zwischen dem Detektionsmodus, in dem die Prüfdiode 14 in Sperrrichtung betrieben wird und, und dem Funktionskontrollmodus, in dem die Prüfdiode in Durchlassrichtung betrieben wird.

In **Figur 4** ist eine beschädigte Folienanordnung 10 dargestellt. Auf der linken Seite ist die Folienanordnung 10 in einer Draufsicht zu sehen, in der man den Schaden als unförmige Aussparung erkennt. Auf der rechten Seite ist schematisch dieselbe geschädigte Folienanordnung 10 in einer Seitenansicht zu erkennen. Einseitig sind die erste und die zweite Leitfolie 11 und 13 mit der Prüfdiode 14 verbunden und auf der dem Schaden gegenüberliegende Seite mit der Steuer- und Kontrolleinheit 15. Vorzugsweise umfasst die Steuer- und Kontrolleinheit 15 eine Spannungsversorgung, die die Prüfdiode 14 vorzugsweise in Sperrrichtung 100 betreibt. Der in der Abbildung gezeigte Schaden bewirkt nun ein Überbrücken der sonst in Sperrrichtung 100 geschalteten Prüfdiode 14, wodurch ein Stromfluss einsetzt, der andernfalls bei derselben Polung der Spanungsversorgung nicht zu erwarten wäre. Insbesondere umfasst die Steuer- und Kontrolleinheit 15 weiterhin eine Vorrichtung zur Detektion des durch den Schaden hervorgerufenen Stroms.

### Bezugszeichenliste

- 1: Schiff
- 2: Detektionsfolie
- 3: Spant
- 4: Stringer
- 5: Außenhaut
- 9: Schaltkreis
- 10: geschichtete Folienanordnung
- 11: erste Leitfolie
- 12: Isolationsfolie
- 13: zweite Leitfolie
- 14: Prüfdiode
- 15: Steuer- und Kontrolleinheit
- 21: Längsbahn
- 22: Querbahn
- 100: Sperrrichtung
- 101: Durchlassrichtung

## Patentansprüche

1. Verfahren zur Detektion eines Schadens an einer Außenhaut (5) eines Schiffes (1) mit einer Folienanordnung (10), bei der eine erste Leitfolie (11) von einer zweiten Leitfolie (13) durch eine Isolationsfolie (12) beabstandet wird, wobei eine elektrische Spannung zwischen der ersten Leitfolie (11) und der zweiten Leitfolie (12) angelegt wird, wobei die elektrische Spannung derart gepolt wird, dass eine parallel zur Folienanordnung (10) geschaltete Prüfdiode (14)
-- in einem Detektionsmodus zur Detektion eines potenziellen Schadens an der Außenhaut des Schiffes (1) in Sperrrichtung (100) und
-- in einem Funktionskontrollmodus zur Prüfung der Detektionsfähigkeit der Folienanordnung (10) in Durchlassrichtung (101)
betrieben wird.

2. Verfahren gemäß Anspruch 2, wobei zwischen dem Detektionsmodus und dem Funktionskontrollmodus gewechselt wird, wobei Prüfdiode (14) länger in Sperrrichtung (100) betrieben wird als in Durchlassrichtung (101).

3. Verfahren gemäß einem der vorhergehenden Ansprüche, wobei die erste Leitfolie (11) und/oder die zweite Leitfolie (13) von einem Folienträger mit darauf rasterförmig angeordneten, elektrisch leitenden Längsbahnen (21) und/oder Querbahnen (22) gebildet wird.

4. Verfahren gemäß dem Anspruch 3, wobei die elektrisch leitenden Längsbahnen (21) und/oder Querbahnen (22) durch eine mit Hilfe eines Druckverfahrens auf dem Folienträger aufgetragenen Beschichtung gebildet werden.

5. Verfahren gemäß einem der vorhergehenden Ansprüche, wobei zwischen einer Ausrichtung der Längsbahnen (21) der ersten Leitfolie (11) und der Ausrichtung der Längsbahnen (21) der zweiten Leitfolie (13) ein von Null verschiedener Winkel, vorzugsweise ein rechter Winkel, ausgebildet wird.

6. Verfahren gemäß einem der vorhergehenden Ansprüche, wobei die erste Leitfolie (11), die zweite Leitfolie (13) und die Isolationsfolie (12) gemeinsam an der Außenhaut (5) des Schiffes (1) angeordnet werden.

7. Verfahren gemäß einem der vorhergehenden Ansprüche, wobei ein System aus der erste Leitfolie (11), der Isolationsfolie (12), der zweiten Leitfolie (13) und der Prüfdiode (14) mit einer Steuer -und Kontrolleinheit (15) betrieben wird.

8. Folienanordnung (10) zur Detektion von Schäden an einem Schiff (1), wobei die Folienanordnung (10) eine zwischen einer ersten Leitfolie (11) und einer zweiten Leitfolie (13) angeordnete Isolationsfolie (12) aufweist, **dadurch gekennzeichnet, dass** eine Prüfdiode parallel zur Folienanordnung (10) geschaltet ist, wobei die Prüfdiode (14) in einem Detektionsmodus zur Detektion eines potenzielles Schadens an der Außenhaut des Schiffes (1) in Sperrrichtung (101) und in einem Funktionskontrollmodus zur Prüfung der Detektionsfähigkeit der Folienanordnung (10) in Durchlassrichtung (100) betreibbar ist.

9. Folienanordnung (10) gemäß Anspruch 8, wobei die erste Leitfolie (11) und/oder die zweite Leitfolie (13) eine rasterförmige Beschichtung bestehend aus elektrisch leitenden Längsbahnen (21) und/oder Querbahnen (22) umfasst.

10. Folienanordnung (10) gemäß Anspruch 8 oder 9, wobei die Folienanordnung (10) an einer Steuer-und Kontrolleinheit (15) angeschlossen ist.

11. Folienanordnung (10) gemäß Anspruch 9, wobei die Längsbahnen (21) und/oder Querbahnen (22) ein Metall oder ein Karbon aufweist.

12. Folienanordnung (10) gemäß einem der Ansprüche 8-11, wobei die Folienanordnung (10) betrieben wird mit einem Verfahren gemäß einem der Ansprüche 1 bis 8.

13. Schiff (1) mit einer Folienanordnung (10) gemäß einem der Ansprüche 8 bis 12.

14. Schiff (1) gemäß Anspruch 13 mit einer Vielzahl an Folienanordnungen (10).

## Claims

1. Method for detecting damage to an outer skin (5) of a ship (1) comprising a foil/film arrangement (10) in which a first conductive foil (11) is spaced apart from a second conductive foil (13) by an insulating film (12), wherein an electrical voltage is applied between the first conductive foil (11) and the second conductive foil (12), wherein the electrical voltage is polarized in such a way that a test diode (14), which is connected in parallel to the foil/film arrangement (10), is operated
-- in the reverse direction (100) in a detection mode for detecting potential damage to the outer skin of the ship (1) and
-- in the forward direction (101) in a function monitoring mode for testing the detection capability of the foil/film arrangement (10).

2. Method according to Claim 2, wherein a changeover is made between the detection mode and the function control mode, wherein the test diode (14) is operated in the reverse direction (100) for longer than in the forward direction (101).

3. Method according to either of the preceding claims, wherein the first conductive foil (11) and/or the second conductive foil (13) are/is formed by a foil carrier comprising electrically conductive longitudinal tracks (21) and/or transverse tracks (22) which are arranged on it in the manner of a grid.

4. Method according to Claim 3, wherein the electrically conductive longitudinal tracks (21) and/or transverse tracks (22) are formed by a coating which is applied to the foil carrier with the aid of a printing process.

5. Method according to one of the preceding claims, wherein an angle which is different from zero, preferably a right angle, is formed between an orientation of the longitudinal tracks (21) of the first conductive foil (11) and the orientation of the longitudinal tracks (21) of the second conductive foil (13).

6. Method according to one of the preceding claims, wherein the first conductive foil (11), the second conductive foil (13) and the insulating film (12) are jointly arranged on the outer skin (5) of the ship (1).

7. Method according to one of the preceding claims, wherein a system comprising the first conductive foil (11), the insulating film (12), the second conductive foil (13) and the test diode (14) is operated by a control and monitoring unit (15).

8. Foil/film arrangement (10) for detecting damage to a ship (1), wherein the foil/film arrangement (10) comprises an insulating film (12) which is arranged between a first conductive foil (11) and a second conductive foil (13), **characterized in that** a test diode is connected in parallel to the foil arrangement (10), wherein the test diode (14) can be operated in the reverse direction (101) in a detection mode for detecting potential damage to the outer skin of the ship (1) and in the forward direction (100) in a function monitoring mode for testing the detection capability of the foil/film arrangement (10).

9. Foil/film arrangement (10) according to Claim 8, wherein the first conductive foil (11) and/or the second conductive foil (13) comprise/comprises a grid-like coating comprising electrically conductive longitudinal tracks (21) and/or transverse tracks (22).

10. Foil/film arrangement (10) according to Claim 8 or 9, wherein the foil/film arrangement (10) is connected to a control and monitoring unit (15).

11. Foil/film arrangement (10) according to Claim 9, wherein the longitudinal tracks (21) and/or transverse tracks (22) comprise/comprises a metal or a carbon.

12. Foil/film arrangement (10) according to one of Claims 8-11, wherein the foil/film arrangement (10) is operated using a method according to one of Claims 1 to 8.

13. Ship (1) comprising a foil/film arrangement (10) according to one of Claims 8 to 12.

14. Ship (1) according to Claim 13 comprising a large number of foil/film arrangements (10).

## Revendications

1. Procédé de détection d'un dommage au niveau d'un bordé (5) d'un navire (1), comprenant un arrangement de films (10), avec lequel un premier film conducteur (11) est espacé d'un deuxième film conducteur (13) par un film isolant (12), une tension électrique étant appliquée entre le premier film conducteur (11) et le deuxième film conducteur (12), la tension électrique étant polarisée de telle sorte qu'une diode de contrôle (14) branchée en parallèle avec l'arrangement de films (10) fonctionne
- dans le sens bloqué (100), dans un mode de détection en vue de détecter un dommage potentiel au niveau du bordé du navire (1) et
- dans le sens passant (101), dans un mode de contrôle du fonctionnement en vue de contrôler l'aptitude à la détection de l'arrangement de films (10).

2. Procédé selon la revendication 2, un basculement entre le mode de détection et le mode de contrôle du fonctionnement étant effectué, la diode de contrôle (14) fonctionnant plus longtemps dans le sens bloqué (100) que dans le sens passant (101).

3. Procédé selon l'une des revendications précédentes, le premier film conducteur (11) et/ou le deuxième film conducteur (13) étant formés par un porte-film sur lequel se trouvent des bandes longitudinales (21) et/ou des bandes transversales (22) électriquement conductrices, disposées en forme de grille.

4. Procédé selon la revendication 3, les bandes longitudinales (21) et/ou les bandes transversales (22) électriquement conductrices étant formées par un revêtement appliqué sur le porte-film à l'aide d'un procédé d'impression.

5. Procédé selon l'une des revendications précédentes, un angle différent de zéro, de préférence un angle droit, étant formé entre une orientation des bandes longitudinales (21) du premier film conducteur (11) et l'orientation des bandes longitudinales (21) du deuxième film conducteur (13).

6. Procédé selon l'une des revendications précédentes, le premier film conducteur (11), le deuxième film conducteur (13) et le film isolant (12) étant disposés ensemble sur le bordé (5) du navire (1).

7. Procédé selon l'une des revendications précédentes, un système composé du premier film conducteur (11), du film isolant (12), du deuxième film conducteur (13) et de la diode de contrôle (14) étant opéré par une unité de commande et de contrôle (15).

8. Arrangement de films (10) destiné à la détection de dommages au niveau d'un navire (1), l'arrangement de films (10) possédant un film isolant (12) disposé entre un premier film conducteur (11) et un deuxième film conducteur (13), **caractérisé en ce qu'**une diode de contrôle est branchée en parallèle avec l'arrangement de films (10), la diode de contrôle (14) pouvant fonctionner dans le sens bloqué (101), dans un mode de détection en vue de détecter un dommage potentiel au niveau du bordé du navire (1) et dans le sens passant (100), dans un mode de contrôle du fonctionnement en vue de contrôler l'aptitude à la détection de l'arrangement de films (10).

9. Arrangement de films (10) selon la revendication 8, le premier film conducteur (11) et/ou le deuxième film conducteur (13) comprenant un revêtement en forme de grille composé de bandes longitudinales (21) et/ou de bandes transversales (22) électriquement conductrices.

10. Arrangement de films (10) selon la revendication 8 ou 9, l'arrangement de films (10) étant raccordé à une unité de commande et de contrôle (15).

11. Arrangement de films (10) selon la revendication 9, les bandes longitudinales (21) et/ou les bandes transversales (22) possédant un métal ou un carbone.

12. Arrangement de films (10) selon l'une des revendications 8 à 11, l'arrangement de films (10) étant opéré avec un procédé selon l'une des revendications 1 à 8.

13. Navire (1) comprenant un arrangement de films (10) selon l'une des revendications 8 à 12.

14. Navire (1) selon la revendication 13, comprenant une pluralité d'arrangements de films (10).
